# EUROPEAN PATENT SPECIFICATION

(11) **EP 4 304 087 B1**
(45) Date of publication and mention of the grant of the patent: **25.03.2026**
(21) Application number: 23178595.7
(22) Date of filing: 12.06.2023
(51) Int. Cl.: H03K 17/082, H03F 1/52, H03F 3/217

(54) **SWITCHING POWER STAGE CIRCUIT ARRANGEMENT WITH CYCLE-BY-CYCLE PROTECTION AGAINST OVER-CURRENTS AND CORRESPONDING SWITCHING METHOD**
SCHALTLEISTUNGSSTUFENSCHALTUNGSANORDNUNG MIT ZYKLUS-ZU-ZYKLUS-SCHUTZ GEGEN ÜBERSTRÖME UND ENTSPRECHENDES SCHALTVERFAHREN
CIRCUIT D'ÉTAGE DE PUISSANCE À DÉCOUPAGE AVEC PROTECTION CYCLE PAR CYCLE CONTRE LES SURINTENSITÉS ET PROCÉDÉ DE COMMUTATION CORRESPONDANT

(30) Priority: 05.07.2022 IT 202200014167
(43) Date of publication of application: 10.01.2024
(73) Proprietor: STMicroelectronics S.r.l., 20864 Agrate Brianza (MB) (IT)
(72) Inventor: BOTTI, Edoardo, I-29029 Vigevano (Pavia) (IT); GONANO, Giovanni, I-35142 Padova (IT); RAIMONDI, Marco, I-20038 Busto Garolfo (Milano) (IT)
(74) Representative: Buzzi, Notaro & Antonielli d'Oulx S.p.A.

(56) References cited:
- EP-A2- 3 054 591
- US-A1- 2022 200 590

## Description

### Technical Field

Embodiments of the present disclosure relate to solutions of switching power stages with cycle-by-cycle protection against over-currents.

Embodiments of the present disclosure relate in particular to half bridge switching power stage, full bridge switching power stages and class D bridge audio amplifiers.

### Background

The protection against over-currents on the output of switching power stages such as power audio amplifiers and other devices operating in a switching mode can be achieved by turning off all the power transistors of the stage (3-state, or three state, condition) once an excess of current flowing in them has been detected. Subsequently, a special circuit switches the power stage back on after a time long enough for the output stage to avoid any damage, such as damage from thermal overload.

If the over-currents were not caused by a wrong connection of the outputs, but were the consequence of a normal driving condition just above the safety current threshold, the power output enters the 3-state condition anyway.

When used on audio power amplifiers, this simple and reliable protection causes the sound to be interrupted, and forces to keep a safe over-current threshold evaluating carefully the maximum voltage and the lowest load impedance. Since impedance is frequency dependent, and the over-current threshold may have a tolerance of 10-20%, this results in a huge limitation of the power delivered by the audio system with respect to the ideal case.

It is often preferred to the above solution using the well-known Cycle-By-Cycle protection, which is more complex and theoretically less reliable, but does not involve the effects of "sound interruption", at least in the event of an over-current due to a load with too low impedance.

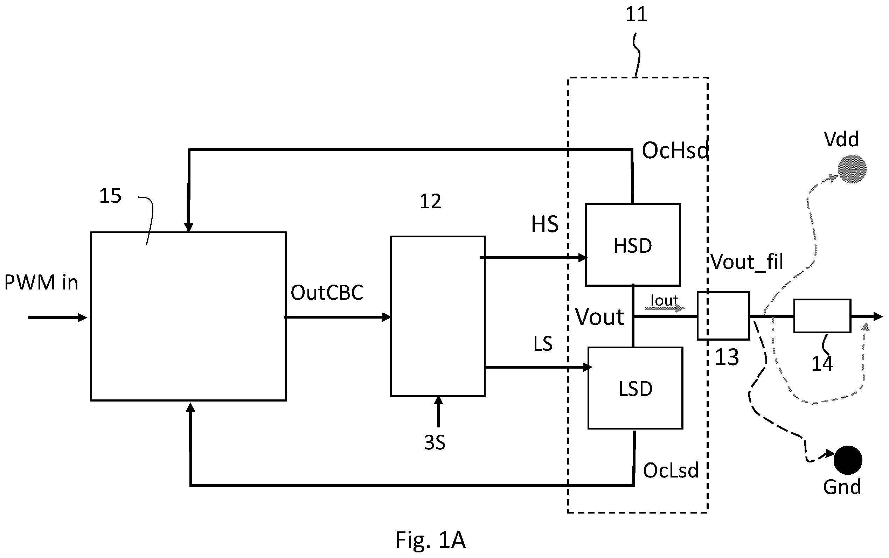

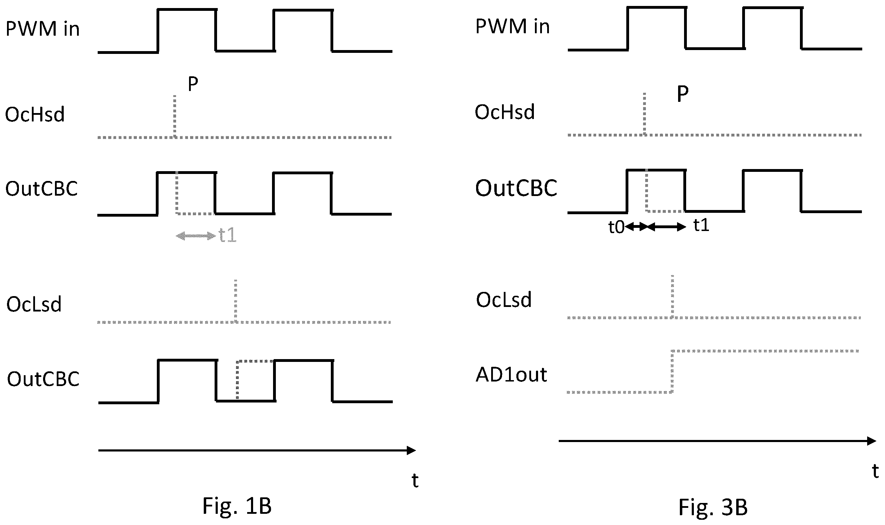

A circuit arrangement operating in such manner is shown in the circuit schematic representation of figure 1A, while figure 1B is a time diagram showing the evolution in time t of the main signals of the circuit arrangement of figure 1A.

With the numerical reference 10 is indicated as whole a circuital arrangement comprising a power stage 11 in the form of a half bridge comprising a high side switch HSD, e.g., a MOSFET, and a low side switch LSD, which are driven by respective high side HS and low side LS driving signal issued by a driver circuit 12. At a common node of the high side switch HSD and low side switch LSD, an output current Iout is sent, through a filter 13, e.g. a LC filter, as filtered voltage Vout_fil, to a load 14.

A cycle-by-cycle protection circuit 15 receives a driving PWM signal PWMin and outputs a cycle-by-cycle protected driving signal OutCBC to the driver 12.

The cycle-by-cycle protection circuit 15 receives also a high side over-current signal OcHsd, i.e., a signal indicative of an over-current flowing in the high side switch HSD, i.e. between source and drain, and a corresponding low side over-current signal OcLsd. The high side over-current signal OcHsd (OcLSD) in the examples shown is a signal, in particular comprising a pulse P when an over-current occurs, i.e. crosses an over-current threshold I1, obtained by a sensor, e.g. threshold comparator, applied to the current flowing in the switch HSD (LSD), signalling that such current is above such threshold value I1. The sensor in variant embodiments may be comprised in the cycle-by-cycle protection circuit 15. In figure 1B thus the over-current signals OcHsd and OcLSD are represented by pulses P (dotted line) issued when the current in the respective switch is above the given over-current threshold I1, in particular in figure 1B it is shown a pulse P in the high side over-current signal OcHsd.

In figure 1A with dashed lined are indicated possible paths of short-circuits from the output of the filter 13, to the supply voltage Vdd and to the ground Gnd.

If, during the time interval in which the high side switch HSD is on, the current flowing in such component crosses the given over-current threshold I1, the output, the cycle-by-cycle protection circuit 15 is configured to invert, the cycle-by-cycle protected driving signal OutCBC, i.e., the current high logic level becomes low logic level, turning off the high side switch HSD and turning on the low side switch LSD, irrespective of the input signal, i.e., the driving PWM signal PWMin.

The high side switch HSD stays switched off until the next transition, in this case from logic zero to logic one, of the driving PWM signal PWMin at input of the cycle-by-cycle protection circuit 15.

In the same way, the operation when the over-current takes places on the low side switch LSD is complementary with respect to that have described previously.

Thus, the cycle-by-cycle protection against over-currents circuit 15 is configured to output said cycle-by-cycle protected driving signal OutCBC as inverted driving PWM signal PWMin, i.e. the same waveform as PWMin with opposite logic levels, if, during the time interval in which one of the high side switch HSD or low side switch LSD is on, the signals indicative of an over-current OcHsd, OcLsd indicate that the current flowing in such switch crosses a given threshold, e.g. I1, turning off the one of the high side switch or low side switch which is on, else the driving PWM signal PWMin is outputted not inverted, i.e. the signal OutCBC coincides with the signal PWMin.

This type of protection can be interesting because, while causing a variation in the output voltage level with respect to the desired one, it does not interrupt operation, as happens instead for the protections which, once a predetermined current threshold is reached, carry both switches, e.g., transistors of output in off condition (upon command of a 3-state signal 3S to the driver 15). This type of protection has however some disadvantage. If an over-current occurs, during the period t1 indicated in figure 1B, starting from the pulse P of the high side over-current signal OcHsd to the end of the one to zero transition of the driving PWM signal PWMin, at the charge of the low side switch LSD, the circuit cannot (and should not) switch over to turn the high side switch HSD back on, and therefore the low side switch LSD would not be protected.

Also, in particular conditions of short circuit towards the supply voltage Vdd or the ground voltage Gnd, the "discharge" of the inductance energy in the filter 13 when the cycle-by-cycle protection circuit 15 intervenes could be lower than the charge when, in the next cycle, the switch HSD, LSD that the cycle-by-cycle protection circuit 15 had turned off turns on again. This causes an uncontrolled tendency to increase the current in the power components, and again the circuit would not be protected.

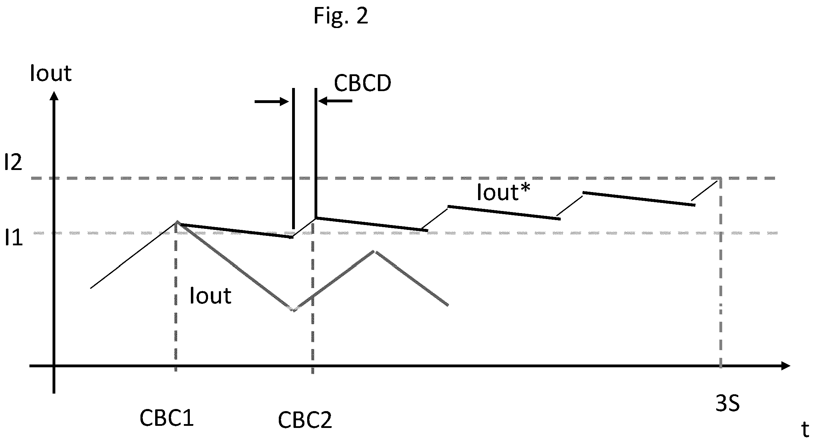

In Figure 2 it is shown a time diagram where the trend of the output current Iout is exemplified in case of:
- a first anomaly determined by a short-circuit on the load 14, cycle-by-cycle threshold current I1, CBC1 indicates the time of intervention of the cycle-by-cycle protection circuit 15 after a delay CBCD, as shown in figure 1A, (controlled current);
- a second anomaly determined by a short circuit to the supply voltage Vdd, in this case the current Iout, indicated with Iout* in the figure, can increase in a not controlled way.

To solve such problems, it is known to use a second detection circuit of the output current, set at the level of a greater protection current threshold I2, indicated in figure 2, which is for instance 20 - 30% higher than the intervention level of the cycle-by-cycle protection against over-currents circuit 15, i.e., cycle-by-cycle threshold I1. The current Iout* increases, crossing the cycle-by-cycle current threshold I1 a second time at time instant CBC2 and then increasing despite the intervention of the cycle-by-cycle protection circuit 15. When the current Iout* passes the greater current threshold I2, the 3-state signal 3S brings both switches, e.g., transistors, in off condition.

Such a solution, besides making more complicate the sensing circuit, requires a level of the protection current threshold I2 which is greater of that, I1, of the CBC circuit, which therefore can be more difficult to set to obtain reliability, or, vice versa, set with a value which limits the performance of the amplifier or circuit using the power stage.

Prior art documents such as US2022/200590 A1 o EP 3054591 A2 are also exemplary of the background technology.

### Summary

On the basis of the foregoing description, the need is felt for solutions which overcome one or more of the previously outlined drawbacks.

According to one or more embodiments, such an object is achieved through a switching power stage circuit arrangement having the features specifically set forth in the claims that follow. Embodiments moreover concerns a related method for switching a power stage circuit arrangement.

The claims are an integral part of the technical teaching of the disclosure provided herein.

As mentioned in the foregoing, the present disclosure provides solutions regarding a switching power stage circuit arrangement comprising
at least a half bridge comprising a respective high side switch and low side switch driven by a PWM signal, and
a cycle-by-cycle protection against over-currents circuit
receiving said driving PWM signal and
configured to output a cycle-by-cycle protected driving signal to drive said high side switch and low side switch,
said cycle-by-cycle protection against over-currents circuit receiving signals indicative of an over-currents detected at said high side switch and low side switch,
said cycle-by-cycle protection against over-currents circuit being configured to output said cycle-by-cycle protected driving signal as inverted driving PWM signal if, during the time interval in which one of the high side switch or low side switch is on, the signals indicative of an over-current indicate that the current flowing in such switch crosses a give threshold, turning off the one of the high side switch or low side switch which is on, else the driving PWM signal is outputted not inverted,
wherein said power stage further comprises an anomaly detection circuit which receives at least the signals indicative of an over-current and it is configured to switch off the high side and low side switches if an anomaly is detected in the pattern of over-current events in the the signals indicative of an over-current.

In variant embodiments, the anomaly detection circuit is configured, if the pattern of over-current events comprises an over-current event on a switch when the cycle-by-cycle protected driving signal commands it off, to detect an anomaly.

In variant embodiments, the anomaly detection circuit is configured, if a further over-current event is signalled in a given time interval after a previous over-current event of the other switch, to detect an anomaly, in particular by performing a logic OR between the high side and low side over-current signals.

In variant embodiments, the anomaly detection circuit is configured, if a further over-current event is signalled in a given time interval after a previous over-current event for a same switch, to detect an anomaly, in particular by performing a logic OR between the high side and low side over-current signals.

In variant embodiments, the anomaly detection circuit receives a clock signal of the driving PWM signal and it is configured to compute said given time interval of a length longer than a cycle of said clock signal, in particular one time and a half said clock signal.

In variant embodiments, the anomaly detection circuit receives also the cycle-by-cycle protected driving signal and the given time interval ends after an elapsed time which starts from the beginning of the clock cycle subsequent to that in which the previous over-current event has taken place.

In variant embodiments, said power stage circuit arrangement is comprised in a class D bridge audio amplifier.

The present disclosure provides also solutions regarding a method for switching a power stage circuit arrangement comprising
at least a half bridge comprising a respective high side switch and low side switch driven by a PWM signal, and
a cycle-by-cycle protection against over-currents circuit
receiving said driving PWM signal and
configured to output a cycle-by-cycle protected driving signal to drive said high side switch and low side switch,
said cycle-by-cycle protection against over-currents circuit receiving signals indicative of an over-currents detected at said high side switch and low side switch,
said cycle-by-cycle protection against over-currents circuit being configured to output said cycle-by-cycle protected driving signal as inverted driving PWM signal if, during the time interval in which one of the high side switch or low side switch is on, the signals indicative of an over-current indicate that the current flowing in such switch crosses a give threshold, turning off the one of the high side switch or low side switch which is on, else the driving PWM signal is outputted not inverted,
wherein said method comprises performing an anomaly detection on the basis of at least the signals indicative of an over-current and
switching off the high side and low side switches if an anomaly is detected in the pattern of over-current events in the the signals indicative of an over-current.

In variant embodiments, if the anomaly detection circuit is configured, if a further over-current event is signalled in a given time interval after a previous over-current event of the other switch, to detect an anomaly.

In variant embodiments, if a further over-current event is signalled in a given time interval (TW) after a previous over-current event of the other switch, to detect an anomaly.

In variant embodiments, if a further over-current event is signalled in a given time interval after a previous over-current event for a same switch, an anomaly is detected.

In variant embodiments, if the pattern of over-current events comprises an over-current event on a switch when the cycle-by-cycle protected driving signal commands it off an anomaly is detected.

In variant embodiments, said anomaly detection operation comprises receiving a clock signal of the driving PWM signal and computing said given time interval of a length longer than a cycle of said clock signal, in particular one time and a half said clock signal.

In variant embodiments, said anomaly detection operation comprises receiving also the cycle-by-cycle protected driving signal and the given time interval ends after an elapsed time which starts from the beginning of the clock cycle subsequent to that in which the previous over-current event has taken place.

### Brief description of the figures

Embodiments of the present disclosure will now be described with reference to the annexed drawings, which are provided purely by way of non-limiting example and in which:
- Figures 1A, 1B and 2 have been already described in the foregoing;
- Figure 3A shows schematically a circuit arrangement according to embodiments;
- Figure 3B represents a time diagram showing signal of the circuit arrangement according to embodiments;
- Figure 4 shows a circuit implementation of the circuit arrangement of Figure 3A;
- Figure 5A shows the circuit diagram of a variant of circuit arrangement according to embodiments;
- Figure 5B represents a time diagram showing signal of the circuit arrangement of figure 5A;
- Figure 6A shows the circuit diagram of a further variant of circuit arrangement according to embodiments;
- Figure 6B represents a time diagram showing signal of the circuit arrangement of figure 6A;
- Figure 7A shows the circuit diagram of a further variant of circuit arrangement according to embodiments;
- Figures 7B and 7C represent a time diagrams showing signal of the circuit arrangement of figure 7A.

### Detailed Description

In the following description, numerous specific details are given to provide a thorough understanding of embodiments. The embodiments can be practiced without one or several specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for convenience only and do not interpret the scope or meaning of the embodiments.

Figures parts, elements or components which have already been described with reference to Figures 1A, 1B and 2 are denoted by the same references previously used in such Figures; the description of such previously described elements will not be repeated in the following in order not to overburden the present detailed description.

The solution here described refers to a switching power stage circuit arrangement with cycle-by-cycle protection against over-currents, in particular a switching audio amplifier, which allows to manage anomalies like the second anomaly indicated above, with short-circuit to the power supply, increasing the current in a not controlled way, without requiring a second greater protection current threshold, thus obtaining a reduction in complexity of the circuit and an improvement of the reliability.

Such a solution is directed to a circuit arrangement which main comprise a single anomaly detector module or two anomaly detector modules, which may be in part or entirely digital. Such a circuit arrangement may comprise only an anomaly detector detecting the second anomaly, e.g., short circuit to the positive or negative power supply with an increasing current trend (Iout* in the previous figure 2), which may be per se configured also to detect the first anomaly (i.e., first anomaly determined by a short-circuit on the load 14, CBC threshold current I1 in figure 2) to solve the drawbacks indicated above.

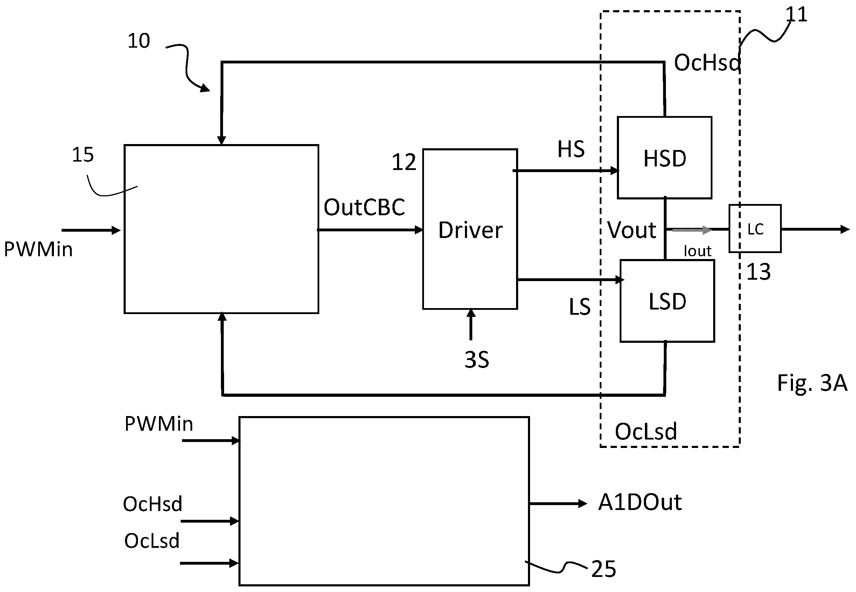

In figure 3A it is represented schematically, alongside the circuital arrangement 10 of power stage already described with reference to figure 1A, a first anomaly detector 25, which is embodied by a logical module receiving the driving PWM signal PWMin, the high side over-current signal OcHsd and the low side over-current signal OcLsd, and then outputting a first anomaly detection signal AD1out, which goes to high logic level, in a latched manner, if
PWMin at 1 AND OcLsd at 1
   OR
PWMin at 0 AND OcHsd at 1
i.e., if the input driving PWM signal PWMin is at the level which turns on the high side switch HSD, in this case high logic or logic one, and receives the low side over-current signal OcLsd, e.g., a pulse P2 in such signal, from the low side switch LSD. This because for that value or level of input driving PWM signal PWMin the low side switch LSD should be turned off, not causing pulses on the low side over-current signal OcLsd.

Based on the above, thus, if the input driving PWM signal PWMin is at the level which turns on the high side switch HSD, in this case high logic or logic one, and a first overcurrent event is detected in such high side switch, i.e., in response to the current flowing in such high side switch crossing the given over-current threshold I1, a pulse P1 is generated in the high side over-current signal OcHsd.

In response to the pulse P1 generated in the high side over-current signal OcHsd, the cycle-by-cycle protection circuit 15 is configured to invert the cycle-by-cycle protected driving signal OutCBC, i.e., the current high logic level becomes low logic level, thus, turning off the high side switch HSD and turning on the low side switch LSD.

Then, if a further over-current event is detected in the low side switch while the input driving PWM signal PWMin is still at the level which turns on the high side switch HSD, a pulse P2 is generated in the low side over-current signal OcLsd.

Therefore, as previously described, if within a same period wherein the input driving PWM signal PWMin is at the level which turns on the high side switch HSD an over-current event occurs on the high side switch, i.e., leading to a first pulse P1 on the high side over-current signal OcHsd, starting from the pulse P1 of the high side over-current signal OcHsd to the end of the one to zero transition of the driving PWM signal PWMin, at the charge of the low side switch LSD, the circuit cannot (and should not) switch over to turn the high side switch HSD back on.

Therefore, in the described conditions, i.e., when PWMin is set to 1, and when the second pulse P2 is raised on the low side over-current signal OcLsd, i.e., when OcLsd is set to 1, an anomaly is detected by the first anomaly detector 25, setting to a high logic level the first anomaly detection signal AD1out.

Similarly, when PWMin is set to 0, and when the second pulse P2 is raised on the high side over-current signal OcHsd, i.e., when OcHsd is set to 1, an anomaly is detected by the first anomaly detector 25, setting to a high logic level the first anomaly detection signal AD1out.

With reference to the time diagram of figure 3B, analogous to figure 1A with respect to the quantities there represented, such a condition is the one that may take place in the time interval t1 in case of a short circuit to a supply voltage Vdd of the circuit or an equivalent event. This is an event which is not frequent, since it would take a short circuit which passes from the output at ground level Gnd to the output at supply voltage between the time interval t0 and the time interval t1. As shown in figure 3B the time interval t0 is the interval corresponding to a driving PWM signal PWMin and the cycle-by-cycle protected driving signal OutCBC at high logic level, before the issuing of the pulse P, and the beginning of the interval t1, i.e., when the cycle-by-cycle protected driving signal OutCBC is forced to zero logic level (dotted line).

This however is what may happen if there is a bridge circuit with the two half bridges driven by the same cycle-by-cycle protected driving signal OutCBC with opposite phases and a short circuit of both the outputs to the ground or to the supply voltages.

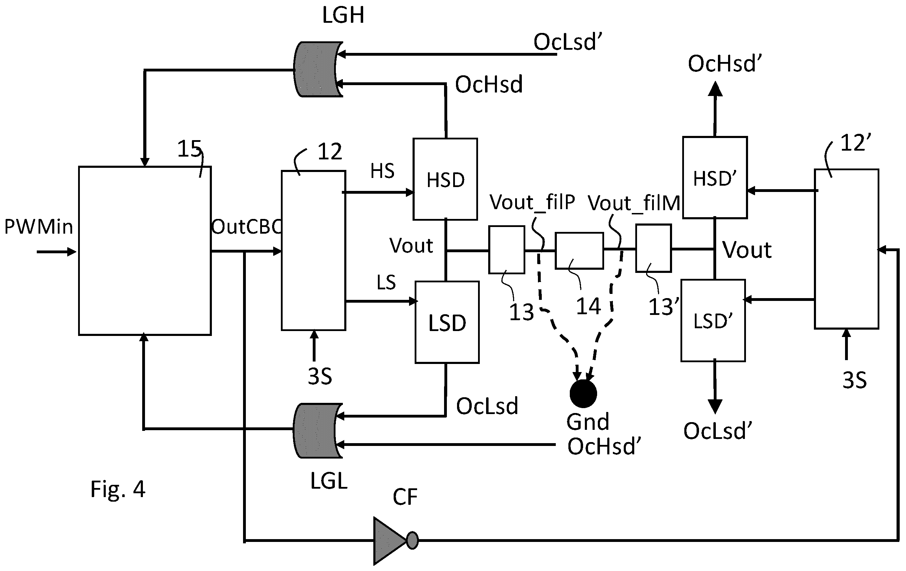

In figure 4 it is shown a CBC protection applied to a bridge architecture, comprising two half bridges, a first half bridge 11 and a second half bridge 11' controlled by respective drivers, a first driver 12 (with first driving signals HS, LS) and a second driver 12' (with second driving signals HS', LS'). The outputs of the two half bridges 11 (with first switches HSD, LSD) and 11' (with second switches HSD', LSD') are coupled to the respective terminals of the load 14 through respective LC filters 13, 13'. The cycle-by-cycle protection against over-currents circuit 15 receives at one input the logic OR (performed in a gate LGH) of the first high side over-current signal OcHsd and of the second low side over-current signal OcLsd' and at the other input the logic OR (performed in a gate LGL) of the first low side over-current signal OcLsd and of the second high side over-current signal OcHsd'. As mentioned, the cycle-by-cycle protected driving signal OutCBC is brought at the input of the first driver 12, and, inverted in a inverter CF, to the second driver 12'. Also, a double short circuit of the load 14 (dashed lines), i.e., applied to each of its terminals, is indicated in figure 4. The first anomaly detection signal AD1out at the output of the first anomaly detector 25 brings the outputs of the half bridges or of the full bridge in 3-state condition, i.e., all the power switches, HSD, LSD, HSD', LSD' are set off.

1.5 PWM clock cycles anomaly detector 35, which receives a clock signal CLK, that may operate at a frequency f_{CLK} which is greater or multiple of the frequency f_{PWM}, and the high side over-current signal OcHsd and low side over-current signal OcLsd outputting a second anomaly detection signal AD2out. The clock signal CLK is, in general, an unmodulated signal, operating at frequency, i.e., f_{CLK}, usually higher than that of the PWM signal. Its purpose is to determine, for instance using counters, the observation interval with sufficient precision. For example, in the exemplary circuit, f_{PWM} is 2 MHz and f_{CLK} is 16 MHz.

The logic module which embodies the second anomaly detector 35 is configured to set such second detection signal AD2out at high logic level, or logic one, (latched) if within a time comprised between 1 to 1.5 PWM clock cycles, i.e., cycles of the clock CLK, after a first over-current event, identified in particular by a pulse, a second over-current occurs on the same switch, e.g., the same high side switch. For the case of a short circuit to the positive or negative power supply with an increasing current trend (Iout* in figure 2), that of the same switch is sufficient. Thus, the anomaly detection circuit 35 is configured, if a further over-current event is signalled in a given time interval after a previous over-current event of the same switch, to detect an anomaly, i.e., the second anomaly.

However, in variant embodiments the anomaly detection circuit 35 may be configured, if a further over-current event is signalled in a given time interval after a previous over-current event of the other switch, to detect an anomaly, i.e., the first anomaly. This may be obtained for instance by performing a logic OR between the high side and low side over-current signals, so that the circuit is able to detect the anomalies, e.g., first anomaly, detected by the anomaly detector 25.

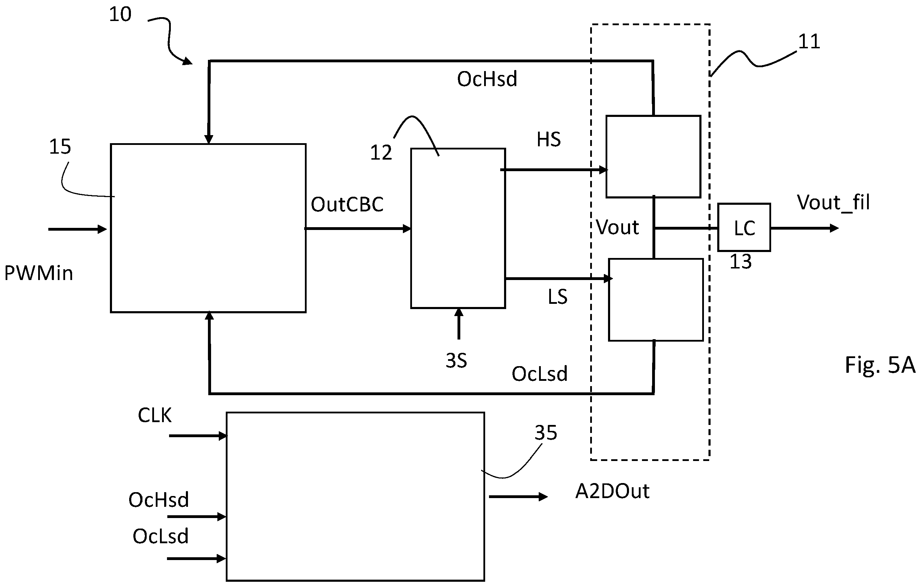

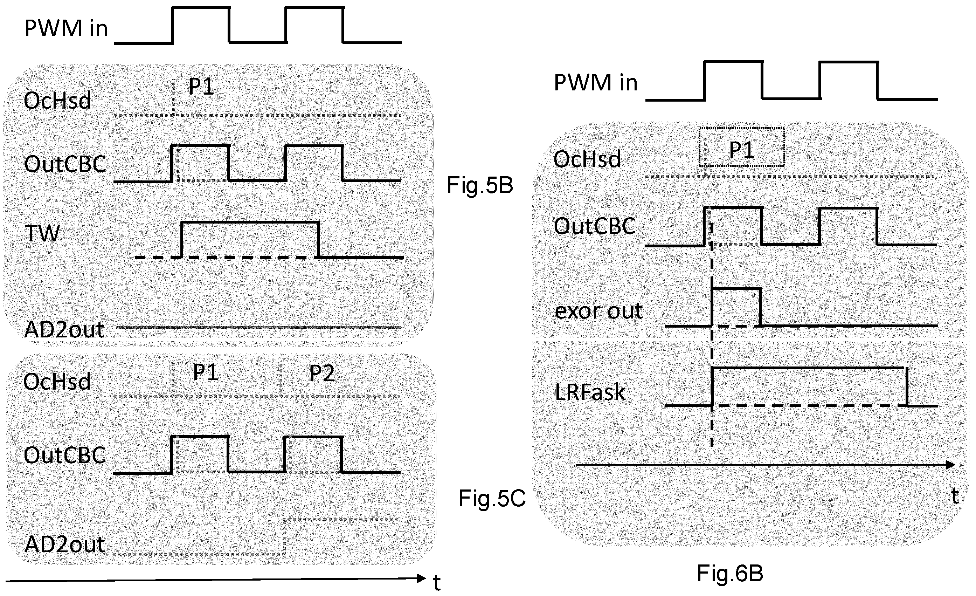

Considering the output current in case of cycle-by-cycle protection and over-current due to a low value load coupled between the filtered output Vout_fil and a potential around half of the supply voltage Vdd, in figure 5B it shown the occurrence of an over-current event, pulse P, on the high side over-current signal OCHsd.

If the output Vout is at supply voltage, when the cycle-by-cycle protection against over-currents circuit 15 intervenes, the high side switch HDS is turned off and the low side switch LSD is turned on. The output Vout goes to low logic value, e.g. zero. The voltage on the inductor in the filter 13 is inverted, thus the current flowing in the inductor decreases with a sharp slope, given by the ratio of the voltage drop on the inductor to the inductance value of the inductor.

Also, in the case output Vout is at supply voltage Vdd, if a short circuit between the filtered output Vout_fil and ground takes place, this determines the activation of the cycle-by-cycle protection against over-currents circuit 15, which turns off the high side switch HSD and turns on the low side switch LSD. The voltage drop on the inductor in the load 13 decreases to low values (e.g., hundredth of mV) and the slope of the current flowing in such inductor as a function of time is also low.

In such circumstances, as mentioned it may happen that during a cycle of PWM modulation, even with the action of the cycle-by-cycle protection against over-currents circuit 15 the energy stored in the inductor when the high side switch HSD is on cannot be entirely discharged during the following cycle, so that the current keeps on increasing at each cycle.

By using the signals CLK, OcHSD and OcLSD it is possible to detect this type of over-current event (i.e., second anomaly) without the necessity of a further over-current detection circuit intervening at a current level (e.g., I2 in figure 2) which may be dangerously higher (from 20 to 40% higher), using the anomaly detector 35.

The operation of the anomaly detector 35 is the following. In figure 5B it is shown a time diagram showing the input driving PWM signal PWMin, the output AD2OUT of detector 35, the high side over-current signal OcHSD, the output CBCout of the cycle-by-cycle protection against over-currents circuit 15 and an observation window TW. Once the cycle-by-cycle protection against over-currents circuit 15 intervenes, indicated by a pulse to high logic level issued following a corresponding pulse P1 (dotted line) in the upon high side over-current signal OcHSD, an observation window TW is activated, having a length of slightly more than a clock CLK period or cycle, for instance 1.5 times the clock CLK period, which is received at the detector 35. If during such clock CLK period, the second anomaly detector 35 does not detect other over-currents, i.e., the over-current signals OcHSD (and OcLSD as well, although not shown) do not present pulses, this identifies the absence of accumulation of current. The second anomaly detection signal AD2OUT of the second anomaly detector 35 stays low.

However, as shown in figure 5C, if in the same clock CLK period a second pulse P2 in the high side over-current signal OcHSD is detected by the detector 35, this means that the situation is critical, thus the second anomaly detector 35 generates a high level in the second anomaly detection signal A2DOUT (latched) which bring the half bridge or the full bridge in the 3-state condition, i.e., the high level second anomaly detection signal A2DOUT is supplied to 3-state input 3S and activate bringing the half bridge or the full bridge in the 3-state condition, i.e., both switches go off determining an high impedance state of the bridge.

The behavior described hereabove with reference to figures 5B, 5C can be obtained for instance by using in the detector 35 a pulse detector, for instance receiving the high side over-current signal OcHsd, which upon receiving the pulse P1 starts a counter, clocked by signal CLK, while receiving a second pulse P2 generates a stop signal for the counter. If the counted time by the counter is less that the observation window TW the second anomaly detection signal AD2OUT is raised. Of course, many other implementations are possible to obtain checking if two overcurrent events in the high side over-current signal OcHsd takes place within the observation window TW.

In this case, the fault is considered to be a short circuit to ground Gnd. The over-current is identified in the high side over-current signal OcHSD. If there is an over-current in the low side switch LSD, the anomaly detector 15 is activated.

For the correct operation of the solution here described it may preferably be required that:
- the PWM output signal OutCBC switches at the frequency F_{pwm} frequency (fixed);
- the load 14 has an impedance behaviour with maximum phase shifts around 60 degrees and with points of minimum impedance essentially of the resistive type. These characteristics are those commonly found in loads such as speakers.

In some cases, for instance to maximize the output power in the audio devices, it is provided that the half bridge can skip some pulses, operating thus at Fpwm/2, Fpwm/4 etc.

Therefore, it may be beneficial to use in connection with the second anomaly detector 35 a circuit as described in the European patent publication EP 3703255 A1, in order to force the PWM generator feeding the driving PWM signal PWMin to output a PWM signal switching at the frequency Fpwm.

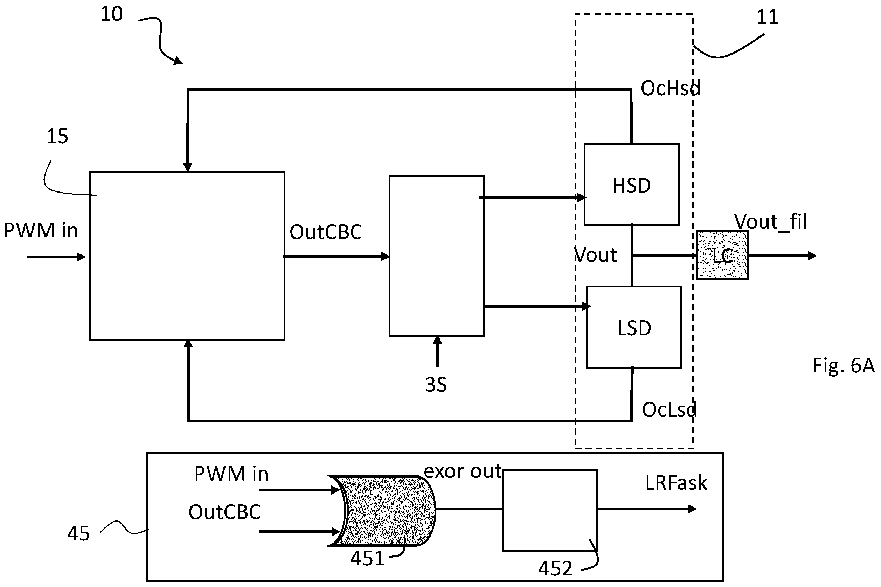

This may be obtained by a circuit comparing the driving PWM signal PWMin and cycle-by-cycle protected driving signal OutCBC, and, if the driving PWM signal PWMin is found different with respect to the cycle-by-cycle protected driving signal OutCBC it is decided that the cycle-by-cycle protection against over-currents circuit 15 has intervened. A reset forcing signal LRFask to reset the switching at frequency Fpwm is issued. As shown in figure 6A, a circuit 45 configure to force a PWM signal switching at the frequency Fpwm may be implemented by an EXOR gate 451 followed by a hold circuit 452 configured to hold the output of the EXOR gate 451 for one clock period, thus outputting the forcing signal LRFask. This is shown in the time diagram of figure 6B, where when a pulse is present in the high side over-current signal OcHSD, the cycle-by-cycle protected driving signal OutCBC goes low due to the action of the cycle-by-cycle protection against over-currents circuit 15 while the driving PWM signal PMWin stays at high logic level. A signal exor out, i.e., the output of the EXOR gate 451 and the input of the hold circuit 452, thus goes high till the next transition of the signal PMWin. The hold circuit 452, forcing signal LRFask, however maintains the high logic level until the end of the clock CLK cycle. In this case, the fault is considered to be a short circuit to ground Gnd. The over-current is identified in the high side over-current signal OcHSD. If there is an over-current in the low side switch LSD, the first anomaly detector 25 is activated.

In the exemplary embodiment of the second anomaly detector 35 shown above, the time constant which determines the duration of the observation window TW after the first over-current may be set with precision using the clock CLK signal, which can be the signal defining the frequency Fpwm of the driving PWM signal PWMin or a signal with a higher, in particular multiple, frequency.

In variant embodiments, the duration of the observation window TW may be set with less precision using a circuit with a RC time constant as time reference, e.g., measuring the time a voltage or current in a RC circuit, e.g., series resistor parallel capacitor, takes to reach a given level, e.g., the tau or τ time constant of the RC circuit, i.e., the RC product. In this case, there is no need for inputting the clock signal CLK to the second anomaly detector 35.

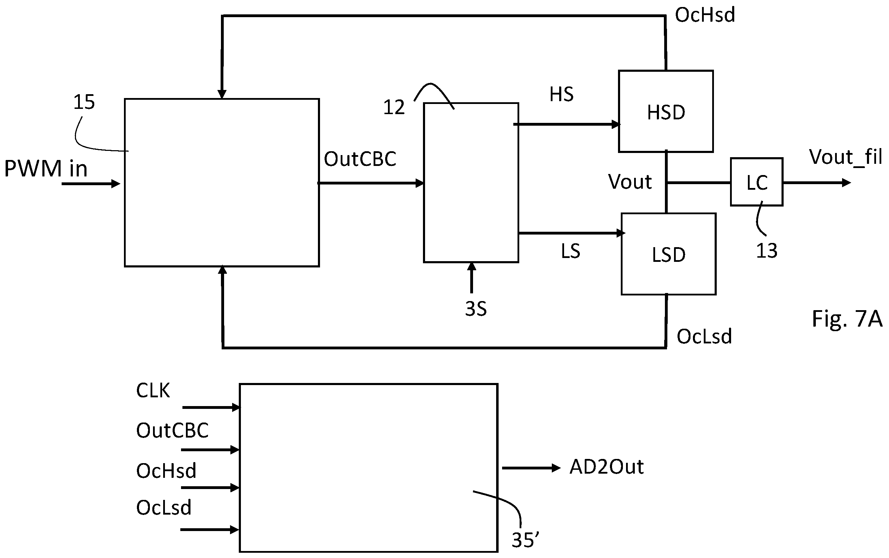

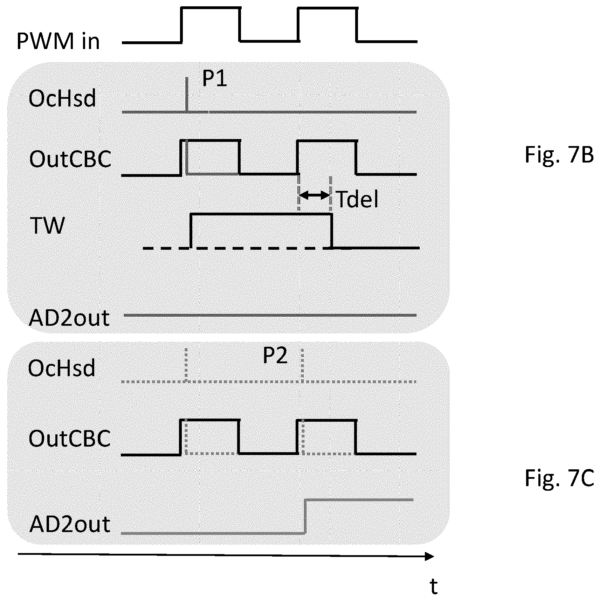

In further variant embodiments, the duration of the observation window TW is not fixed. The observation window TW ends after an elapsed time Tdel, which starts from the beginning of the clock cycle subsequent to that in which the over-current event has taken place. In such a case, the second anomaly detector, here indicated with 35', receives also the cycle-by-cycle protected driving signal OutCBC, further to the clock signal CLK and the over-current signals. As shown in figure 7B which represents a time diagram of the signals, after the first over-current (pulse P1) the observation window TW is opened, but after the elapsed time Tdel from the beginning of the next cycle of the driving PWM signal PWMin the observation window TW is closed, i.e., the signal TW goes low, thus the second detection signal AD2OUT stays low all the time.

In figure 7C is then shown that if within the elapsed time Tdel after next clock cycle a second over-current (pulse P2) takes place, then the second anomaly detector 35' sets such second detection signal AD2out at high logic level or logic one (latched).

In this case less restrictions are applied to the type of load which can be used.

Also in this case, if a high precision is not needed, a RC circuit may be used to count the elapsed time Tdel, thus it is not necessary to provide the clock signal CLK as input to the second anomaly detector 35'.

It is underlined that preferably the switching power stage circuit arrangement here described preferably makes use of the second detector 35, or 35', while the power circuit arrangement here described may be further configured to detect also the first anomaly, either by, as mentioned, modifying the second detector 35 or 35 or by adding the first anomaly detector 25.

It is here underlined however that the description is here directed also to a switching power stage circuit arrangement like the one described in figure 1A which further comprises only the first anomaly detector 25.

It is here underlined that detectors 25, 35, and 35' as disclosed herein are configured to allow at least an over-current event P, P1 before detecting an anomaly, i.e., a further over-current event P2 is needed in the pattern of events before that the anomaly detection circuits signal to enter the 3-state condition.

Thus, from the description here above the advantages of the described solution are clear.

The solution proposed simplify the "dual threshold CBC concept" and improves the reliability because reduces the maximum threshold current.

Advantageously, the solution here described is directed to a switching power stage circuit arrangement with cycle-by-cycle protection against over-currents, in particular a switching audio amplifier, which allows to solve the prior art drawbacks without requiring a second greater protection current threshold, thus obtaining a reduction in complexity of the circuit and an improvement of the reliability.

The circuit arrangement described thus simplifies and improves the reliability of the Cycle-by-cycle protection. The processing of the over-currents and clock signals are sufficient to protect the PWM system also in case of short circuits causing an energy accumulation in the output coil.

## Claims

1. A switching power stage circuit arrangement comprising
at least a half bridge (11) comprising a respective high side switch (HSD) and low side switch (LSD) driven (12) by a PWM signal (PWMin), and
a cycle-by-cycle protection against over-currents circuit (15)
receiving said driving PWM signal (PWMin) and
configured to output a cycle-by-cycle protected driving signal (OutCBC) to drive said high side switch (HSD) and low side switch (LSD),
said cycle-by-cycle protection against over-currents circuit (15) receiving signals indicative of an over-currents (OcHsd, OcLsd) detected at said high side switch (HSD) and low side switch (LSD),
said cycle-by-cycle protection against over-currents circuit (15) being configured to output said cycle-by-cycle protected driving signal (OutCBC) as inverted driving PWM signal (PWMin) if, during the time interval in which one of the high side switch (HSD) or low side switch (LSD) is on, the signals indicative of an over-current (OcHsd, OcLsd) indicate that the current flowing in such switch crosses a give threshold (I1), turning off the one of the high side switch or low side switch which is on, else the driving PWM signal (PWMin) is outputted not inverted,
**characterized in that**
said power stage (10) further comprises at least an anomaly detection circuit (25; 35; 35') which receives at least the signals indicative of an over-current (OcHsd, OcLsd) and it is configured to switch off the high side (HSD) and low side (LSD) switches if an anomaly is detected in the pattern of over-current events (P, P1) in the signals indicative of an over-current (OcHsd, OcLsd).

2. A power stage circuit arrangement according to claim 1, wherein the anomaly detection circuit (35) is configured, if a further over-current event is signalled in a given time interval (TW) after a previous over-current event of the same switch, to detect an anomaly.

3. A power stage circuit arrangement according to claim 2, wherein the anomaly detection circuit (35) is configured, if a further over-current event is signalled in a given time interval (TW) after a previous over-current event of the other switch, to detect an anomaly, in particular by performing a logic OR between the high side and low side over-current signals (OcHsd, OcLsd).

4. A power stage circuit arrangement according to claim 1 or 2, wherein the anomaly detection circuit (25) is configured, if the pattern of over-current events (P, P1) comprises an over-current event on a switch (HSD, LSD) when the cycle-by-cycle protected driving signal (OutCBC) commands it off, to detect an anomaly.

5. A power stage circuit arrangement according to claim 2 or 3, wherein the anomaly detection circuit (35) receives a clock signal (CLK), which frequency is equal or greater than, in particular multiple of, the frequency (Fpwm) of the driving PWM signal (PWMin), and it is configured to compute on the basis of said clock signal (CLK) said given time interval (TW) of a length longer than a cycle of the frequency (Fpwm) of the driving PWM signal (PWMin) in particular one time and a half said clock signal (CLK).

6. A power stage circuit arrangement according to claim 5, wherein the anomaly detection circuit (35') receives also the cycle-by-cycle protected driving signal (OutCBC) and the given time interval (TW) ends after an elapsed time (Tdel) which starts from the beginning of the driving PWM signal (PWMin) cycle subsequent to that in which the previous over-current event (P1) has taken place.

7. A power stage circuit arrangement according to any of the previous claims, wherein said power stage circuit arrangement is comprised in a class D bridge audio amplifier.

8. Method for switching a power stage circuit arrangement comprising
at least a half bridge (11) comprising a respective high side switch (HSD) and low side switch (LSD) driven (12) by a PWM signal (PWMin), and
a cycle-by-cycle protection against over-currents circuit (15)
receiving said driving PWM signal (PWMin) and
configured to output a cycle-by-cycle protected driving signal (OutCBC) to drive said high side switch (HSD) and low side switch (LSD),
said cycle-by-cycle protection against over-currents circuit (15) receiving signals indicative of an over-currents (OcHsd, OcLsd) detected at said high side switch (HSD) and low side switch (LSD),
said cycle-by-cycle protection against over-currents circuit (15) being configured to output said cycle-by-cycle protected driving signal (OutCBC) as inverted driving PWM signal (PWMin) if, during the time interval in which one of the high side switch (HSD) or low side switch (LSD) is on, the signals indicative of an over-current (OcHsd, OcLsd) indicate that the current flowing in such switch crosses a give threshold (I1), turning off the one of the high side switch or low side switch which is on, else the driving PWM signal (PWMin) is outputted not inverted,
**characterized in that**
said method comprises performing an anomaly detection (25; 35) on the basis of at least the signals indicative of an over-current (OcHsd, OcLsd) and
switching off the high side (HSD) and low side (LSD) switches if an anomaly is detected in the pattern of over-current events (P, P1) in the the signals indicative of an over-current (OcHsd, OcLsd).

9. A method according to claim 8, wherein if a further over-current event is signalled in a given time interval (TW) after a previous over-current event for a same switch, an anomaly is detected.

10. A method according to claim 9, wherein if a further over-current event is signalled in a given time interval (TW) after a previous over-current event of the other switch, to detect an anomaly.

11. A method according to claim 9 or 10, wherein if the pattern of over-current events (P, P1) comprises an over-current event on a switch when the cycle-by-cycle protected driving signal (OutCBC) commands it off an anomaly is detected.

12. A method according to claim 9 or 10, wherein said anomaly detection operation (35) comprises receiving a clock signal (CLK) of the driving PWM signal (PWMin) and computing said given time interval (TW) of a length longer than a cycle of the frequency (Fpwm) of the driving PWM signal (PWMin) in particular one time and a half said clock signal (CLK).

13. A method according to claim 12, wherein said anomaly detection operation (35') comprises receiving also the cycle-by-cycle protected driving signal (OutCBC) and the given time interval (TW) ends after an elapsed time (Tdel) which starts from the beginning of the driving PWM signal (PWMin) cycle subsequent to that in which the previous over-current event (P1) has taken place.

## Patentansprüche

1. Schaltleistungsstufen-Schaltungsanordnung, umfassend mindestens eine Halbbrücke (11), die einen jeweiligen High-Side-Schalter (HSD) und Low-Side-Schalter (LSD) umfasst, die von einem PWM-Signal (PWMin) angesteuert (12) werden, und
eine zyklusweise Überstromschutzschaltung (15), die das PWM-Ansteuersignal (PWMin) empfängt und
so konfiguriert ist, dass sie ein zyklusweise geschütztes Ansteuersignal (OutCBC) ausgibt, um den High-Side-Schalter (HSD) und den Low-Side-Schalter (LSD) anzusteuern,
wobei die zyklusweise Überstromschutzschaltung (15) Signale empfängt, die auf einen an dem High-Side-Schalter (HSD) und dem Low-Side-Schalter (LSD) erkannten Überstrom (OcHsd, OcLsd) hinweisen,
wobei die zyklusweise Überstromschutzschaltung (15) so konfiguriert ist, dass sie das zyklusweise geschützte Ansteuersignal (OutCBC) als invertiertes PWM-Ansteuersignal (PWMin) ausgibt, wenn während des Zeitintervalls, in dem einer des High-Side-Schalters (HSD) oder des Low-Side-Schalters (LSD) eingeschaltet ist, die Signale, die auf einen Überstrom (OcHsd, OcLsd) hinweisen, darauf hinweisen, dass der in einem solchen Schalter fließende Strom einen bestimmten Schwellenwert (I1) überschreitet, wodurch der eine des High-Side-Schalters oder des Low-Side-Schalters, der eingeschaltet ist, ausgeschaltet wird, andernfalls wird das PWM-Ansteuersignal (PWMin) nicht invertiert ausgegeben, **dadurch gekennzeichnet, dass** die Leistungsstufe (10) ferner mindestens eine Anomalieerkennungsschaltung (25; 35; 35') umfasst, die mindestens die Signale empfängt, die auf einen Überstrom (OcHsd, OcLsd) hinweisen, und so konfiguriert ist, dass sie den High-Side-Schalter (HSD) und den Low-Side-Schalter (LSD) ausschaltet, wenn eine Anomalie in dem Muster von Überstromereignissen (P, P1) in den Signalen, die auf einen Überstrom (OcHsd, OcLsd) hinweisen, erkannt wird.

2. Leistungsstufenschaltungsanordnung nach Anspruch 1, wobei die Anomalieerkennungsschaltung (35) so konfiguriert ist, dass sie eine Anomalie erkennt, wenn ein weiteres Überstromereignis in einem bestimmten Zeitintervall (TW) nach einem vorherigen Überstromereignis desselben Schalters signalisiert wird.

3. Leistungsstufenschaltungsanordnung nach Anspruch 2, wobei die Anomalieerkennungsschaltung (35) so konfiguriert ist, dass sie, wenn ein weiteres Überstromereignis in einem bestimmten Zeitintervall (TW) nach einem vorherigen Überstromereignis des anderen Schalters signalisiert wird, eine Anomalie erkennt, insbesondere durch Ausführen einer logischen ODER-Funktion zwischen den High-Side- und Low-Side-Überstromsignalen (OcHsd, OcLsd).

4. Leistungsstufenschaltungsanordnung nach Anspruch 1 oder 2, wobei die Anomalieerkennungsschaltung (25) so konfiguriert ist, dass sie eine Anomalie erkennt, wenn das Muster der Überstromereignisse (P, P1) ein Überstromereignis an einem Schalter (HSD, LSD) umfasst, wenn das zyklusweise geschützte Ansteuersignal (OutCBC) befiehlt, ihn auszuschalten.

5. Leistungsstufenschaltung nach Anspruch 2 oder 3, wobei die Anomalieerkennungsschaltung (35) ein Taktsignal (CLK) empfängt, dessen Frequenz gleich oder größer als insbesondere ein Vielfaches der Frequenz (Fpwm) des PWM-Ansteuersignals (PWMin) ist, und so konfiguriert ist, dass sie auf der Grundlage des Taktsignals (CLK) das bestimmte Zeitintervall (TW) mit einer Länge berechnet, die länger ist als ein Zyklus der Frequenz (Fpwm) des PWM-Ansteuersignals (PWMin), insbesondere eineinhalb Mal so lang wie das Taktsignal (CLK).

6. Leistungsstufenschaltungsanordnung nach Anspruch 5, wobei die Anomalieerkennungsschaltung (35') auch das zyklusweise geschützte Ansteuersignal (OutCBC) empfängt und das bestimmte Zeitintervall (TW) nach einer abgelaufenen Zeit (Tdel) endet, die mit dem Beginn des Zyklus des PWM-Ansteuersignals (PWMin) beginnt, der auf den folgt, in dem das vorherige Überstromereignis (P1) stattgefunden hat.

7. Leistungsstufenschaltungsanordnung nach einem der vorhergehenden Ansprüche, wobei die Leistungsstufenschaltungsanordnung in einem Brücken-Audioverstärker der Klasse D umfasst ist.

8. Verfahren zum Schalten einer Leistungsstufenschaltungsanordnung, umfassend mindestens eine Halbbrücke (11), die einen jeweiligen High-Side-Schalter (HSD) und Low-Side-Schalter (LSD) umfasst, die von einem PWM-Signal (PWMin) angesteuert (12) werden, und
eine zyklusweise Überstromschutzschaltung (15), die das PWM-Ansteuersignal (PWMin) empfängt und
so konfiguriert ist, dass sie ein zyklusweise geschütztes Ansteuersignal (OutCBC) ausgibt, um den High-Side-Schalter (HSD) und den Low-Side-Schalter (LSD) anzusteuern,
wobei die zyklusweise Überstromschutzschaltung (15) Signale empfängt, die auf einen an dem High-Side-Schalter (HSD) und dem Low-Side-Schalter (LSD) erkannten Überstrom (OcHsd, OcLsd) hinweisen,
wobei die zyklusweise Überstromschutzschaltung (15) so konfiguriert ist, dass sie das zyklusweise geschützte Ansteuersignal (OutCBC) als invertiertes PWM-Ansteuersignal (PWMin) ausgibt, wenn während des Zeitintervalls, in dem einer des High-Side-Schalters (HSD) oder des Low-Side-Schalters (LSD) eingeschaltet ist, die Signale, die auf einen Überstrom (OcHsd, OcLsd) hinweisen, darauf hinweisen, dass der in einem solchen Schalter fließende Strom einen bestimmten Schwellenwert (I1) überschreitet, wodurch der eine des High-Side-Schalters oder des Low-Side-Schalters, der eingeschaltet ist, ausgeschaltet wird, andernfalls wird das PWM-Ansteuersignal (PWMin) nicht invertiert ausgegeben, **dadurch gekennzeichnet, dass** das Verfahren das Durchführen einer Anomalieerkennung (25; 35) auf der Grundlage mindestens der Signale, die auf einen Überstrom (OcHsd, OcLsd) hinweisen, und
das Abschalten des High-Side-Schalters (HSD) und des Low-Side-Schalters (LSD) umfasst, wenn eine Anomalie in dem Muster der Überstromereignisse (P, P1) in den Signalen erkannt wird, die auf einen Überstrom (OcHsd, OcLsd) hinweisen.

9. Verfahren nach Anspruch 8, wobei eine Anomalie erkannt wird, wenn ein weiteres Überstromereignis in einem bestimmten Zeitintervall (TW) nach einem vorherigen Überstromereignis für denselben Schalter signalisiert wird.

10. Verfahren nach Anspruch 9, wobei eine Anomalie erkannt wird, wenn ein weiteres Überstromereignis in einem bestimmten Zeitintervall (TW) nach einem vorherigen Überstromereignis des anderen Schalters signalisiert wird.

11. Verfahren nach Anspruch 9 oder 10, wobei eine Anomalie erkannt wird, wenn das Muster von Überstromereignissen (P, P1) ein Überstromereignis an einem Schalter umfasst, wenn das zyklusweise geschützte Ansteuersignal (OutCBC) befiehlt, ihn auszuschalten.

12. Verfahren nach Anspruch 9 oder 10, wobei der Anomalieerkennungsvorgang (35) das Empfangen eines Taktsignals (CLK) des PWM-Ansteuersignals (PWMin) und das Berechnen des bestimmten Zeitintervalls (TW) mit einer Länge, die länger ist als ein Zyklus der Frequenz (Fpwm) des PWM-Ansteuersignals (PWMin), insbesondere eineinhalb Mal so lang wie das Taktsignal (CLK), umfasst.

13. Verfahren nach Anspruch 12, wobei der Anomalieerkennungsvorgang (35') auch das Empfangen des zyklusweise geschützten Ansteuersignals (OutCBC) umfasst und das bestimmte Zeitintervall (TW) nach einer abgelaufenen Zeit (Tdel) endet, die mit dem Beginn des Zyklus des PWM-Ansteuersignals (PWMin) beginnt, der auf den folgt, in dem das vorherige Überstromereignis (P1) stattgefunden hat.

## Revendications

1. Agencement de circuit d'étage de puissance à découpage comprenant :
au moins un demi-pont (11) comprenant un commutateur côté haut (HSD) et un commutateur côté bas (LSD) respectifs pilotés (12) par un signal PWM (PWMin), et
un circuit de protection cycle par cycle contre les surintensités (15) recevant ledit signal PWM (PWMin) pilote et configuré pour sortir un signal pilote protégé cycle par cycle (OutCBC) pour piloter lesdits commutateur côté haut (HSD) et commutateur côté bas (LSD),
ledit circuit de protection cycle par cycle contre les surintensités (15) recevant des signaux indiquant une surintensité (OcHsd, OcLsd) détectée au niveau desdits commutateur côté haut (HSD) et commutateur côté bas (LSD),
ledit circuit de protection cycle par cycle contre les surintensités (15) étant configuré pour sortir ledit signal pilote protégé cycle par cycle (OutCBC) comme signal PWM (PWMin) pilote inversé si, pendant l'intervalle de temps pendant lequel le commutateur côté haut (HSD) ou le commutateur côté bas (LSD) est sur on, les signaux indiquant une surintensité (OcHsd, OcLsd) indiquent que le courant s'écoulant dans un tel commutateur passe un seuil donné (I1), mettre sur off l'un du commutateur côté haut ou du commutateur côté bas qui est sur on, sinon le signal PWM (PWMin) est sorti non inversé,
**caractérisé en ce que** ledit étage de puissance (10) comprend en outre au moins un circuit de détection d'anomalie (25; 35; 35') qui reçoit au moins les signaux indiquant une surintensité (OcHsd, OcLsd) et qu'il est configuré pour mettre sur off les commutateurs côté haut (HSD) et côté bas (LSD) si une anomalie est détectée dans le motif d'évènements de surintensité (P, P1) dans les signaux indiquant une surintensité (OcHsd, OcLsd).

2. Agencement de circuit d'étage de puissance selon la revendication 1, dans lequel le circuit de détection d'anomalie (35) est configuré pour, si un autre évènement de surintensité est signalé dans un intervalle de temps donné (TW) après un précédent évènement de surintensité du même commutateur, détecter une anomalie.

3. Agencement de circuit d'étage de puissance selon la revendication 2, dans lequel le circuit de détection d'anomalie (35) est configuré pour, si un autre évènement de surintensité est signalé dans un intervalle de temps donné (TW) après un précédent évènement de surintensité de l'autre commutateur, détecter une anomalie, en particulier en réalisant un OU logique entre les signaux de surintensité côté haut et côté bas (OcHsd, OcLsd).

4. Agencement de circuit d'étage de puissance selon la revendication 1 ou 2, dans lequel le circuit de détection d'anomalie (25) est configuré pour, si le motif d'évènements de surintensité (P, P1) comprend un évènement de surintensité sur un commutateur (HSD, LSD) quand le signal pilote protégé cycle par cycle (OutCBC) commande son état off, détecter une anomalie.

5. Agencement de circuit d'étage de puissance selon la revendication 2 ou 3, dans lequel le circuit de détection d'anomalie (35) reçoit un signal d'horloge (CLK), dont la fréquence est supérieure ou égale à, en particulier multiple de, la fréquence (FpWm) du signal PWM (PWMin) pilote, et il est configuré pour calculer en se basant sur ledit signal d'horloge (CLK) ledit intervalle de temps donné (TW) d'une longueur plus longue qu'un cycle de la fréquence (FpWm) du signal PWM (PWMin) pilote en particulier une fois et demi ledit signal d'horloge (CLK).

6. Agencement de circuit d'étage de puissance selon la revendication 5, dans lequel le circuit de détection d'anomalie (35') reçoit aussi le signal pilote protégé cycle par cycle (OutCBC) et l'intervalle de temps donné (TW) se termine après un temps écoulé (Tdel) qui commence à partir du début du cycle de signal PWM (PWMin) pilote suivant celui dans lequel le précédent évènement de surintensité (P1) a eu lieu.

7. Agencement de circuit d'étage de puissance selon l'une quelconque des revendications précédentes, dans lequel ledit agencement de circuit d'étage de puissance est compris dans un amplificateur audio à pont de classe D.

8. Procédé de commutation d'un agencement de circuit d'étage de puissance comprenant :
au moins un demi-pont (11) comprenant un commutateur côté haut (HSD) et un commutateur côté bas (LSD) respectifs pilotés (12) par un signal PWM (PWMin), et
un circuit de protection cycle par cycle contre les surintensités (15) recevant ledit signal PWM (PWMin) pilote et configuré pour sortir un signal pilote protégé cycle par cycle (OutCBC) pour piloter lesdits commutateur côté haut (HSD) et commutateur côté bas (LSD),
ledit circuit de protection cycle par cycle contre les surintensités (15) recevant des signaux indiquant une surintensité (OcHsd, OcLsd) détectée au niveau desdits commutateur côté haut (HSD) et commutateur côté bas (LSD),
ledit circuit de protection cycle par cycle contre les surintensités (15) étant configuré pour sortir ledit signal pilote protégé cycle par cycle (OutCBC) comme signal PWM (PWMin) pilote inversé si, pendant l'intervalle de temps pendant lequel l'un du commutateur côté haut (HSD) ou du commutateur côté bas (LSD) est sur on, les signaux indiquant une surintensité (OcHsd, OcLsd) indiquent que le courant s'écoulant dans un tel commutateur passe un seuil donné (I1), mettre sur off l'un du commutateur côté haut ou du commutateur côté bas qui est sur on, sinon le signal PWM (PWMin) est sorti non inversé,
**caractérisé en ce que** ledit procédé comprend de réaliser une détection d'anomalie (25; 35) en se basant sur au moins les signaux indiquant une surintensité (OcHsd, OcLsd) et
de mettre sur off les commutateurs côté haut (HSD) et côté bas (LSD) si une anomalie est détectée dans le motif d'évènements de surintensité (P, P1) dans les signaux indiquant une surintensité (OcHsd, OcLsd).

9. Procédé selon la revendication 8, dans lequel si un autre évènement de surintensité est signalé dans un intervalle de temps donné (TW) après un précédent évènement de surintensité du même commutateur, une anomalie est détectée.

10. Procédé selon la revendication 9, dans lequel si un autre évènement de surintensité est signalé dans un intervalle de temps donné (TW) après un précédent évènement de surintensité de l'autre commutateur, détecter une anomalie.

11. Procédé selon la revendication 9 ou 10, dans lequel si le motif d'évènements de surintensité (P, P1) comprend un évènement de surintensité sur un commutateur quand le signal pilote protégé cycle par cycle (OutCBC) commande son état off une anomalie est détectée.

12. Procédé selon la revendication 9 ou 10, dans lequel ladite opération de détection d'anomalie (35) comprend de recevoir un signal d'horloge (CLK) du signal PWM (PWMin) pilote et de calculer ledit intervalle de temps donné (TW) d'une longueur plus longue qu'un cycle de la fréquence (FpWm) du signal PWM (PWMin) pilote, en particulier une fois et demi ledit signal d'horloge (CLK).

13. Procédé selon la revendication 12, dans lequel ladite opération de détection d'anomalie (35') comprend de recevoir aussi le signal pilote protégé cycle par cycle (OutCBC) et l'intervalle de temps donné (TW) se termine après un temps écoulé (Tdel) qui commence à partir du début du cycle de signal PWM (PWMin) pilote suivant celui dans lequel le précédent évènement de surintensité (P1) a eu lieu.
